(19) Europäisches Patentamt
European Patent Office
Office européen des brevets

(11) Publication number: 0 220 121
A2

# (12) EUROPEAN PATENT APPLICATION

(21) Application number: 86402270.2

(22) Date of filing: 13.10.86

(51) Int. Cl.[4]: **B 41 C 1/14**
G 03 F 7/12

(30) Priority: 14.10.85 JP 228445/85
06.11.85 JP 248427/85

(43) Date of publication of application:
29.04.87 Bulletin 87/18

(84) Designated Contracting States:
CH DE FR GB IT LI

(71) Applicant: Shin-Etsu Chemical Co., Ltd.
6-1, Ohtemachi 2-chome
Chiyoda-ku Tokyo 100 (JP)

(72) Inventor: Susumu, Ueno
Dogou Shataku 3-308 9809-7, Yatabe
Hazaki-cho Kashima-gun Ibaraki-ken (JP)

Toru, Nakanishi
Yushi-ryo 3-3-24, Shitte-chuo
Kamisu-cho Kashima-gun Ibaraki-ken (JP)

(74) Representative: Armengaud Ainé, Alain et al
Cabinet ARMENGAUD AINE 3 Avenue Bugeaud
F-75116 Paris (FR)

## (54) A method for the preparation of a screen mesh for screen printing.

(57) The screen mesh for screen printing is prepared by first subjecting a polyester- or nylon-made base mesh to a treatment with low temperature plasma of an inorganic gas under a reduced pressure to such an extent that the surface of the base mesh is wettable with a wetting solution having a specified wettability index and then forming a layer of a specific photosensitive resin thereon. The most preferable photosensitive resin is a polyvinyl alcohol modified with styryl pyridinium groups. As a result of such a unique method for preparation, the mesh has a greatly improved adhesive strength between the photosensitive resin layer and the base mesh as well as resistance of the resin layer against organic solvents so that the process of screen printing can be performed with improved productivity to give printed matters of better quality even by use of a screen mesh after prolonged storage

EP 0 220 121 A2

**Description**

A METHOD FOR THE PREPARATION OF A SCREEN MESH FOR SCREEN PRINTING

BACKGROUND OF THE INVENTION

The present invention relates to an improved method for the preparation of a screen mesh for screen printing. More particularly, the invention relates to a method for the preparation of a mesh for screen printing having improved adhesion between the base mesh and the photosensitive resin layer formed thereon along with remarkably improved durability in screen printing therewith.

As is known, the process of screen printing is performed by use of a printing screen prepared by providing a photosensitive resinous layer on a fine mesh made of filaments, of which the photosensitive resinous layer is patterned by the photolithographic techniques. The meshes for such a printing screen were traditionally made of silk or very fine stainless steel wires. These traditional materials have several disadvantages, For example, silk-made meshes are defective in respect of the strength and dimensional stability while stainless steel-made meshes are not satisfactory in respect of elastic recovery and instantaneous repulsiveness if not to mention the expensiveness of both of these materials. In this regard, these traditional materials are being replaced more and more with filaments of polyester or nylon or, in particular, polyester utilizing their high dimensional stability. The meshes made of the filaments of these synthetic resins are of course not free from some problems including the poor receptivity of the conventional photosensitive resin emulsion to form a photosensitive resinous layer on the mesh due to the hydrophobicity of polyesters and nylons so that a uniform and sufficiently thick photosensitive layer can be formed only be repeating the coating works requiring handikraft-like skillfulness of the workers. Moreover, the adhesive bonding strength of the thus formed photosensitive resinous layer to the surface of the base mesh is low and poorly resistant against organic solvents used in the course of the printing works with the printing screen so that the durability of the printing screen is usualy unsatisfactory. Moreover, conventional photosensitive resin emulsions containing a diazo compound or a bichromate as the photosensitizing ingredient are poorly storable when the base emulsion and the photosensitizer have been mixed together. For example, curing of the resinous ingredient in the emulsion gradually proceeds in the presence of the photosensitizer even when the emulsion is stored in a dark and cool place and, though somewhat dependent on the types of the emulsion resins, troubles are sometimes caused in the photolithographic patterning when a photosensitive emulsion stored for 2 weeks or longer after mixing of the photosensitizer is used in respect of the removability of the resinous layer from the areas unexposed to light so that such a screen mesh is substantially without practical value.

In order to overcome the above described problems and disadvantages in the prior art printing meshes for screen printing in respect of the storability of the photosensitive emulsion and the insufficient resolving power of patterning, various types of ready-mixed photosensitive resins have been developed in recent years without using any diazo compound or bichromate but the adhesion of these newly developed photosensitive resins to polyester- or nylon-made base meshes is still poorer than the conventional photosensitive resin emulsions so that the problem of the poor adhesion between the base mesh and the photosensitive resinous layer is far from complete solution.

Attempts and proposals have been made in order to enhance the adhesive bonding strength between the polyester- or nylon-made base mesh and the photosensitive resin by the surface treatment of the filaments including chemical treatments using an acid, alkali and the like, flame treatment, corona treatment and so on although none of these methods of surface treatment can exhibit quite satisfactory effects in addition to the problem that the strength of the filaments is considerably decreased by the treatment.

SUMMARY OF THE INVENTION

The inventors have undertaken extensive investigations with an object to provide a novel method for the preparation of a screen mesh for screen printing without the above described problems and disadvantages in the prior art and arrived at a discovery leading to the establishment of the present invention.

Thus, the method of the present invention for the preparation of a screen mesh printing comprises the steps of: (a) subjecting a base mesh made of filaments of polyester or nylon and having a fineness of at least 100 meshes per inch to a treatment with low temperature plasma of an inorganic gas under a pressure in the range from 0.005 to 10 Torr to such an extent that the surface of the filaments is wettable with a wetting reagent having a wettability index of at least 40; and (b) forming a layer of a photosensitive resin having a thickness in the range from 5 to 800 μm on the thus plasma-treated base mesh, the photosensitive resin being modified with a styryl pyridinium group, benzoin compound or acetophenone compound.

DETAILED DESCRIPTION OF THE PREFERRED EMBODIMENTS

As is understood from the above described summary of the invention, the most characteristic feature of the inventive method consists in the hydrophilic treatment of the base mesh with low temperature plasma to a specific extent followed by the formation of a photosensitive resinous layer thereon using a specific photosensitive resin.

Namely, the first step of the inventive method is the treatment of a polyester- or nylon-made base mesh with low tem perature plasma. The base mesh should have a fineness of at least 100 meshes or. preferably, in the

range of 100 to 400 meshes. After cleaning in a usual manner, the base mesh is set in a chamber for plasma generation and low temperature plasma is generated therein by impressing a high frequency electric power at a frequency of 10 kHz to 100 MHz between the electrodes while the atmosphere inside the plasma chamber is kept under a reduced pressure of 0.005 to 10 Torr by the balance of continuous evacuation and continuous introduction of an inorganic gas. It is of course that the frequency band of the power is not limited to the high-frequency range but can be direct current, low frequency or microwaves.

The electrodes should preferably be installed inside the plasma chamber though not particularly limitative thereto. For example, the electrodes can be installed outside the plasma chamber or a single work-coil electrode surrounding the plasma chamber may be used. At any rate, it is important that the base mesh under the plasma treatment is free from the thermal influence by the heat of electric discharge in order to avoid any thermal denaturation of the material forming the mesh. A variety of electrode designs are possible. For example, the form of the electrodes is not particularly limitative including plate-like, ring-like, rod-like and cylindrical ones. The grounded and power electrodes may be of the same form or may be or different forms from each other. A convenient design is that the metal-made inner walls of the plasma chamber may serve as the grounded electrode with one or more of power electrodes installed therein. The power electrode is usually made of a metal such as copper, iron, aluminum and the like. It is preferable that the surface of at least the power electrode is provided with an insulating coating having a withstand voltage of 10000 volts or higher formed of a heat-resistant material such as glass, porcelain enamel, ceramic and the like. Rod-like electrodes provided with an insulating coating layer are preferable in respect of the efficiency in the generation of effective localized plasma.

The electric power to be impressed between the electrodes should be adequately selected in consideration of the effect to be obtained and the deirable length of time within which the plasma treatment should be completed. The plasma treatment can be complete within a shorter time when the electric power is larger as a matter of course. When the material of the base mesh under the plasma treatment is a polyester, the power should be relatively large due to the high heat resistance of polyester resins in comparison with nylons although the electric power should be limited within a range not to cause thermal decomposition and denaturation of the base mesh by the heat evolved in the plasma discharge. The electric power should be controlled relative to the power density on the surface of the power electrode and a power density of at least 5 kilowatts/$m^2$ is desirable from the standpoint of working efficiency.

The inorganic gases suitable for supporting the plasma discharge inside the plasma chamber include helium, neon, argon, nitrogen, nitrous oxide, nitrogen dioxide, oxygen, air, carbon monoxide, carbon dioxide, hydrogen, chlorine, hydrogen chloride, sulfur dioxide, hydrogen sulfide and the like. These gases may be used either singly or as a mixture of two kinds or more according to need.

The pressure of the atmosphere inside the plasma chamber should be in the range from 0.005 to 10 Torr or, preferably, in the range from 0.1 to 10 Torr. When the pressure is too low, the desired effect of improvement of the surface property cannot be fully obtained in respect of the adhesion between the polyester- or nylon-made base mesh and the photosensitive resin applied thereto. An excessively high pressure, on the other hand, is undesirable due to the difficulty in maintaining the plasma discharge with stability.

When adequately treated with low temperature plasma, marked improvements can be obtained in the surface properties of the polyester or nylon filaments forming the base mesh such as the increased hydrophilicity and adhesive bonding strength of the photosensitive resin applied thereto. The strength of the base mesh is little affected by the plasma treatment. For example, a polyester- or nylon-made base mesh after the plasma treatment may retain a strength of larger than 90 % of that before the plasma treatment so that the problem of decreased strength of the mesh unavoidable in the prior art treatments to cause breaking thereof in the course of framing can be solved. In this regard, the adequateness of the extent of the plasma treatment can be estimated in terms of the wettability of the surface. A procedure to test the wettability is performed according to JIS K 6768 by spreading one of the test solutions in series prepared by mixing ethyleneglycol monomethyl ether and formamide in varied mixing ratios using a cotton applicator and visually examining the condition of the liquid film after a length of time on the mesh with the respective test solutions to record the particular test solution which can wet the mesh while no wetting can be obtained with a test solution containing formamide in a smaller mixing ratio than in the particular wettable test solution. The wetting tension of the particular wettable test solution at 23°C in dyn/cm is referred to as the wettability index of the mesh hereinbelow. In this regard of wettability of the base mesh, the plasma treatment of the base mesh should be performed until the plasma-treated base mesh is wettable with the test solution or wetting reagent having a wettability index of at least 40 or, preferably, at least 45.

The polyester- or nylon-made base mesh after the plasma treatment in the above described manner is washed with water and dried and then transferred to the process of forming a photosensitive resinous layer thereon. The photosensitive resin used for forming the photosensitive layer on the plasma-treated base mesh should be modified with a styryl pyridinium group, benzoin compound or acetophenone compound. Polymeric resins modified with styryl pyridinium groups in the molecular structure are particularly preferred.

The styryl pyridinium groups to be incorporated into the molecular structure of a polymeric resin are exemplified by various groups expressed by the following structural formulas:

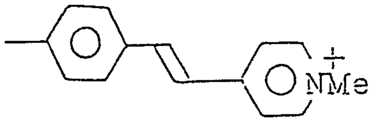 ; 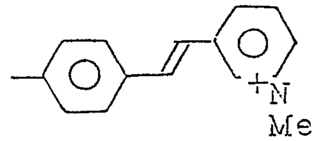 ;

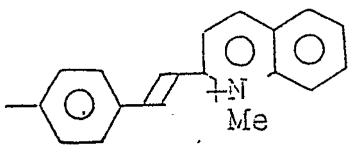 ; 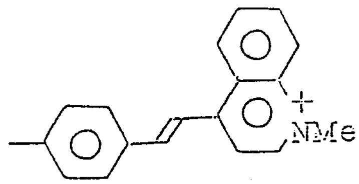 ;

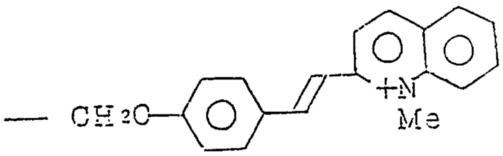 ; 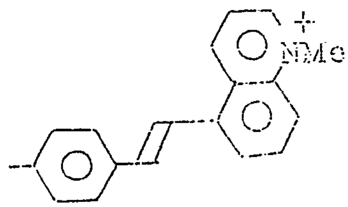 and

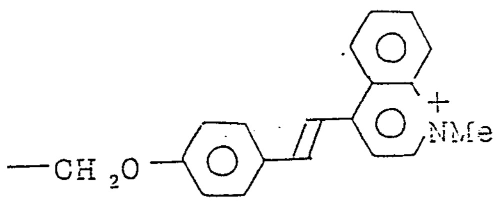 .

The benzoin compound above mentioned includes benzoin, benzoin methyl ether, benzoin ethyl ether, benzoin isopropyl ether and the like. The acetophenone compound above mentioned includes acetophenone, 4-methyl acetophenone, w-bromoacetophenone and the like.

The polymeric base resins to which the styryl pyridinium groups are to be incorporated to give a photosensitive resin include polyvinyl alcohols, copolymers of vinyl alcohol and vinyl acetate, silicone resins, acrylic resins and the like. The method for forming a photosensitive resinous layer on the base mesh using the above described photosensitive resin is not particularly limitative. For example, the plasma-treated polyester- or nylon-made base mesh is coated with an aqueous emulsion or an organic solution of the photosensitive resin and dried to give a layer of the photosensitive resin. Alternatively, the photosensitive resin is shaped in advance in a form of a thin film and the plasma-treated base mesh and the resin film are bonded together under a suitable pressure with heating. When the photosensitive resin is in the form of an aqueous emulsion, the applicability of the aqueous emulsion to the base mesh is greatly improved owing to the hydrophilicity of the base mesh as a result of the plasma treatment. Accordingly, the thickness of the photosensitive resinous layer on the base mesh can be controlled more accurately than in the prior art. While the photosensitive resinous layer should have a thickness in the range from 5 to 800 μm or, preferably, from 5 to 500 μm, for example, the thickness of the photosensitive resinous layer can be controlled within a variation of ±3 μm of the target thickness. The photosensitive resinous layer thus formed is complete without defects such as pin-holes.

The screen mesh having a photosensitive resinous layer on a base mesh according to the above described inventive method is very advantageous over conventioal products in respect of the high adhesive resinous layer thereon as well as good stability in storage. For example, the screen mesh of the invention is storable for as long as 6 months or longer after preparation without affecting the performance in the patterning of very fine patterns having a line width of 50 μm or smaller and the thus formed pattern of the photosensitive resin exhibits unexpectedly high durability in printing and anti-solvent resistance.

The process of patterning on the invention screen mesh is performed using an ultraviolet lamp such as high-pressure mercury lamps, xenon lamps and the like having an output of, for example, about 4 kilowatts as the light source at a distance of 1 to 1.5 meters for 1 to 6 minutes. The integral dose of light should preferably be in the range from 200 to 700 $mJ/cm^2$.

As is mentioned above, one of the advantages obtained in the inventive screen mesh is the storability of the mesh provided with the photosensitive resinous layer. In the conventional screen mesh using a photosensitive resin in the form of an aqueous emulsion containing a diazo compound as the photosensitizer, the emulsion

after addition of the photosensitizer is poorly storable and no satisfactory results can be obtained by use of an emulsion stored, for example, for 2 weeks or longer after admixture of the photosensitizer due to the partial crosslinking reaction of the photosensitive resin gradually proceeding even in dark to give no sharp boundary between the exposed and unexposed areas by development or to cause incomplete removal of the resin in the unexposed areas by development. Such defects in a patterned screen mesh is fatal when the mesh is used in high-precision printing works as in the printing of a pattern for printed circuits and the like. These problems and disadvantages are completely solved by use of the screen mesh prepared by the inventive method which is storable over a long period of time so that the productivity of the printing process can be greatly improved.

Another advantage obtained with the inventive screen mesh is the high durability of the mesh in screen printing which is due to the very firm adhesion of the patterned photosensitive resinous layer to the base mesh and the high anti-solvent resistance of the resin against organic solvents used in the printing works for cleaning the mesh. In particular, the patterned layer has greatly improved resistance against chlorinated solvents, e.g. trichloroethylene and methylene chloride, ketones, e.g. acetone and methyl ethyl ketone, alcohols, e.g. methyl alcohol, ethyl alcohol and isopropyl alcohol, and aromatic solvents, e.g. toluene and xylene, as well as ethyl acetate, ethyleneglycol monoethyl ether, ethyleneglycol monobutyl ether, cyclohexane and the like. In the conventional screen meshes for screen printing, the resistance of the patterned resinous layer against these solvents is rather low so that the patterned lines sometimes fall of the base mesh in the cleaning step of the mesh to remove the printing ink using these solvents, especially, when the width of the patterned line is 50 µm or smaller while such a problem can be completely solved in the inventive screen mesh.

In the following, the present invention is described in more detail by way of examples and comparative examples. In the following, the evaluation of the sheet mesh was performed in two ways of, one, the peeling resistance test with an adhesive tape and, the other, solvent resistance test. The procedure of each of these tests was as follows.

Peeling resistance test with adhesive tape

An adhesive filament tape (#880, a product by Sumitomo MMM Co.) was applied and bonded to the printing screen prepared using the screen mesh by forming a checkerboard-like pattern of 20 lines and 50 rows to give 1000 checkerboard squares of each 0.5 mm by 0.5 mm wide and the adhesive tape was peeled off. This process of application and peeling of the adhesive tape was repeated three times and the number of the checkerboard squares removed as being carried by the adhesive tape was recorded in each time.

Solvent resistance test

The printing screen prepared by the screen mesh by forming the checkerboard pattern in the above described manner was dipped for 5 minutes in an organic solvent at room temperature and, after pulling up out of the solvent and drying, subjected to the same peeling resistance test with an adhesive tape as above to record the number of the removed checkerboard squares.

Example 1 and Comparative Examples 1 and 2.

A polyester-made base mesh of 250 meshes fineness (a product by Nippon Tokushu Orimono Co.) was set in a plasma chamber of an apparatus for low temperature plasma treatment and the chamber was evacuated to have a pressure of 0.01 Torr. Then, oxygen gas was continuously introduced into the chamber at such a rate that the pressure inside the chamber was maintained at 0.06 Torr by the balance with continued evacuation. While keeping the above mentioned atmospheric conditions inside the chamber, a high-frequency electric power of 45 kilowatts at a frequency of 110 kHz was impressed between the electrodes installed inside the chamber to generate low temperature plasma to which the mesh was exposed for about 15 seconds. The thus plasma-treated mesh was wettable with a test solution having a wettability index of 54. Namely, the wettability of the base mesh had been substantially improved in comparison with the mesh before the low temperature plasma treatment which was wettable with a test solution having a wettability index of 37.

The thus plasma-treated polyester-made mesh was washed with a 0.1% aqueous solution of a neutral detergent followed by drying and then coated with a styryl pyridinium-modified polyvinyl alcohol-based photosensitive resin (a product by Murakami Screen Co.) followed by drying to give a film thickness of 10 to 12 µm by repeating coating and drying.

A checkerboard pattern of 1000 checkerboard squares was formed on the screen mesh prepared in the above described manner by the exposure to ultraviolet light through a photomask for 1.5 minutes using a high-pressure mercury lamp of 4 kilowatts output at a distance of 1.4 meters followed by development to remove the layer of the resin in the unexposed areas by dipping the mesh in water for 3 minutes followed by spraying with water.

Further printing meshes were prepared in the same manner as above for comparative purpose except that the treatment with low temperature plasma was omitted (Comparative Example 1) or the styryl pyridinium-modified polyvinyl alcohol-based photosensitive resin was replaced with a conventional diazo-sensitized photosensitive resin emulsion (NK-14, a product by Hoechst Co., West Germany) (Comparative Example 2) without subjecting the base mesh to the low temperature plasma treatment

These three screen meshes provided with the checkerboard pattern were each subjected to the peeling resistance test and the solvent resistance test to record the number of the checkerboard squares removed as being carried by the adhesive tape. The results are shown in Table 1 given below.

Table 1

| | | Peeling resistance test | | | Solvent resistance test | |
|---|---|---|---|---|---|---|
| | | 1st time | 2nd time | 3rd time | Methyl ethyl ketone | Methylene chloride |
| Example 1 | | 0 | 0 | 0 | 0 | 0 |
| Comparative Example | 1 | 15 | 32 | 57 | 241 | ca. 800 |
| | 2 | 2 | 15 | 16 | 105 | 323 |

Example 2 and Comparative Examples 3 and 4.

The experimental procedure in each of Example 1 and Comparative Examples 3 and 4 was the same as in Example 1 and Comparative Examples 1 and 2, respectively, except that the polyester-made base mesh was replaced with a nylon-made mesh of 270 meshes fineness (a product by Nippon Tokushu Orimono Co.) and the film thickness of the photosensitive resin on the base mesh was 8 to 10 µm. The base meshes before and after the low temperature plasma treatment were wettable with test solutions having wettability indices of 38 and 54, respectively. The results of the peeling resistance test and the solvent resistance test are shown in Table 2 given below.

Table 2

| | | Peeling resistance test | | | Solvent resistance test | |
|---|---|---|---|---|---|---|
| | | 1st time | 2nd time | 3rd time | Methyl ethyl ketone | Methylene chloride |
| Example 2 | | 0 | 0 | 0 | 0 | 0 |
| Comparative Example | 3 | 15 | 32 | 57 | 40 | ca. 483 |
| | 4 | 2 | 15 | 16 | 28 | 152 |

Example 3 and Comparative Examples 5 and 6.

A screen mesh provided with a photosensitive resinous layer in each of Example 3 and Comparative Examples 5 and 6 was prepared in just the same manner as in Example 1 and Comparative Examples 1 and 2, respectively. A line pattern was formed on the mesh through a photomask having a line width of 50 µm in the same manner as in the preceding examples after storage of the screen mesh for 1, 3 or 6 months at 5 to 20° C and the thus formed line pattern on the mesh was checked using an electron microscope to examine the increase of the width of the line pattern over 50 µm and completeness of removal of the resin from the areas unexposed to light. The results are shown in Table 3 below, in which the results are rated in three grades of A, B and C each having the following meaning of evaluation.

Line width increase

A: The patterned line had a width of 50 ± 5µm.

B: The increase in the line width was larger than 5 µm.

C: The patterned line had a width of 110 µm or larger with blurred edges.

Completeness of resin removal

A: The resin in the unexposed areas had been removed completely.

B: The mesh openings were partly filled with the unremoved resin to decrease the effective open area.

C: The mesh openings were mostly filled with the resin hardly to allow passage of the printing ink therethrough.

It was noted in the electron microscopic examination of the line patterns that the adhesion of the line

patterns to the base mesh was complete when the printing screen was prepared using the plasma-treated base mesh even after 6 months of storage while the line patterns formed on the base mesh without the plasma treatment were found to be at least slightly lifted from the base mesh over the whole surface of the mesh.

Table 3

| | | Line width increase after storage for | | | Resin removal from unexposed areas, after storage for | | |
|---|---|---|---|---|---|---|---|
| | | 1 month | 3 months | 6 months | 1 month | 3 months | 6 months |
| Example 3 | | A | A | A | A | A | A |
| Comparative Example | 5 | A | B | B | — | — | — |
| | 6 | B | C | C | B | C | C |

Example 4 and Comparative Example 7.

The experimental procedure in Example 3 and Comparative Example 7 was substantially the sama as in Example 1 and Comparative Example 1, respectively, except that the styryl pyridinium-modified polyvinyl alcohol-based photosensitive resin was replaced with a benzoin-sensitized acrylic resin as the photosensitive resin prepared by admixing an acrylic resin (Excel 6, a product by Kurita Kagaku Kenkyusho Co.) with 0.7 % by weight of benzoin isopropyl ether as a photosensitizer and the integral dose of light in the exposure to ultraviolet was 250 mJ/cm$^2$. Table 4 below shows the results of the peeling resistance test and the solvent resistance test carried out in the same manner as in Example 1.

Table 4

| | Peeling resistance test | | | Solvent resistance test | |
|---|---|---|---|---|---|
| | 1st time | 2nd time | 3rd time | Methyl ethyl ketone | Methylene chloride |
| Example 2 | 0 | 0 | 0 | 0 | 0 |
| Comparative Example | ca.700 | ca.100 | ca.100 | ca.800 | ca.1000 |

As is understood from the results shown in Table 4, the peeling resistance and solvent resistance of the mesh could be substantially improved according to the method of the invention.

Example 5 and Comparative Example 8

The experimental procedure in Example 5 and Comparative Example 8 was just the same as in Example 4 and Comparative Example 7, respectively, except that the benzoin compound as the photosensitizer was replaced with 4-methyl acetophenone in an amount of 0.5 % by weight based on the acrylic resin. The results in Example 5 were as satisfactory as in Example 4. The storage test of the screen mesh before exposure to ultraviolet carried out in the same manner as in Example 3 indicated that the storability of the mesh in Example 5 was quite satisfactory without being affected by 6 months or longer of storage while the adhesion of the line patterns formed on the mesh without the plasma treatment in Comparative Example 8 was poor when the mesh was stored for 3 months or longer prior to exposure to ultraviolet with slight lifting of the patterned lines over the whole surface of the mesh.

## Claims

1. A method for the preparation of a screen mesh for screen printing which comprises the steps of:
   (a) subjecting a base mesh made of filaments of polyester or nylon and having a fineness of at least 100 meshes per inch to a treatment with low temperature plasma of an inorganic gas under a pressure in the range from 0.005 to 10 Torr to such an extent that the surface of the filaments is wettable with a wetting reagent having a wettability index of at leasr 40: and
   (b) forming a layer of a photosensitive resin having a thickness in the range from 5 to 800 µm on the thus plasma-treated base mesh, the photosensitive resin being modified with a styryl pyridinium group, benzoin compound or acetophenone compound.
2. The method for the preparation of a screen mesh for screen printing as claimed in claim 1 wherein the photosensitive resin is a polyvinyl alcohol modified with styryl pyridinium groups.
3. The method for the preparation of a screen mesh for screen printing as claimed in claim 1 wherein the low temperature plasma treatment is performed to give an integral dose of light of 200 to 700 mJ/$cm^2$ on the base mesh.